(19) Europäisches Patentamt
European Patent Office
Office européen des brevets

(11) EP 2 671 253 B1

(12) **EUROPÄISCHE PATENTSCHRIFT**

(45) Veröffentlichungstag und Bekanntmachung des Hinweises auf die Patenterteilung:
**19.02.2020 Patentblatt 2020/08**

(21) Anmeldenummer: **11804970.9**

(22) Anmeldetag: **02.12.2011**

(51) Int Cl.:
***H01L 29/06*** *(2006.01)* ***H01L 29/78*** *(2006.01)*
***H01L 29/739*** *(2006.01)* ***H01L 29/861*** *(2006.01)*

(86) Internationale Anmeldenummer:
**PCT/EP2011/071590**

(87) Internationale Veröffentlichungsnummer:
**WO 2012/103968 (09.08.2012 Gazette 2012/32)**

(54) **HALBLEITERANORDNUNG MIT REDUZIERTEM EINSCHALTWIDERSTAND**

SEMICONDUCTOR DEVICE WITH REDUCED ON-RESISTANCE

DISPOSITIF SEMI-CONDUCTEUR LATÉRAL AYANT UNE RÉSISTANCE REDUITE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.02.2011 DE 102011003456**

(43) Veröffentlichungstag der Anmeldung:
**11.12.2013 Patentblatt 2013/50**

(73) Patentinhaber: **Robert Bosch GmbH**
**70442 Stuttgart (DE)**

(72) Erfinder:
- **QU, Ning**
**72770 Reutlingen (DE)**
- **GOERLACH, Alfred**
**72127 Kusterdingen (DE)**

(56) Entgegenhaltungen:
**DE-A1-102009 000 135**
**US-A- 6 037 632**
**US-A1- 2005 167 742**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 671 253 B1

## Beschreibung

Die Erfindung betrifft eine Halbleiteranordnung mit reduziertem Einschaltwiderstand.

Stand der Technik

Leistungs-MOS-Feldeffekttransistoren werden seit langer Zeit als schnelle Schalter für Anwendungen in der Leistungselektronik eingesetzt. Neben planaren, doppelt diffundierten Strukturen (DMOS) finden zunehmend Leistungs-MOSFETs mit Grabenstrukturen (TrenchMOS) Verwendung.

Fig.1 zeigt einen vereinfachten Querschnitt einer Anordnung eines TrenchMOS. Auf einem hoch $n^+$-dotierten Siliziumsubstrat 1 befindet sich eine n-dotierte Siliziumschicht 2 (Epischicht), in die eine Vielzahl von Gräben (Trenches) 3 eingebracht ist, wobei in der Fig.1 nur ein Trench exemplarisch dargestellt ist. An den Seitenwänden und am Boden der Gräben befindet sich jeweils eine dünne, meist aus Siliziumdioxid bestehende, dielektrische Schicht 4. Das Innere der Gräben ist mit einem leitfähigen Material 5, beispielsweise mit dotiertem Polysilizium, ausgefüllt. Zwischen den Gräben befindet sich eine p-dotierte Schicht (p-well) 6. In diese p-dotierte Schicht sind an der Oberfläche hoch $n^+$-dotierte Bereiche 8 (Source) und hoch $p^+$-dotierte Bereiche 7 (zum Anschluss der p-well) eingebracht. Die Oberfläche der gesamten Struktur ist mit einer leitfähigen Schicht 9, beispielsweise mit Aluminium, bedeckt, die mit den $p^+$- bzw. $n^+$-dotierten Schichten 7 und 8 einen ohmschen Kontakt herstellt. Eine dicke, dielektrische Schicht 10, beispielsweise eine CVD-Oxidschicht, isoliert die leitfähige Polysiliziumschicht 5 von der Metallisierung 9. Die Polysilizumschichten 5 sind miteinander und mit einem nicht eingezeichneten metallischen Gatekontakt galvanisch verbunden. Dazu sind an einer Stelle auf der Chipoberfläche die dielektrische Schicht 10 und die Metallschicht 9 geöffnet. Über der Polysiliziumschicht 5 ist in dieser Metallöffnung eine weitere, nicht eingezeichnete und von der Metallisierungsschicht 9 elektrisch isolierte, inselförmige Metallschicht angebracht. Sie kontaktiert die Polysiliziumschicht 5 und dient als Gateanschluss.

Auf der Rückseite des Chips befindet sich ebenfalls eine Metallisierungsschicht 11. Sie stellt den elektrischen Kontakt zum hoch $n^+$-dotierten Siliziumsubstrat 1 dar. Die Metallschicht 9 bildet den Sourcekontakt S, die Metallschicht 11 den Drainkontakt D und die nicht eingezeichnete inselförmige Metallschicht den Gatekontakt G. Die Metallisierung 9 bzw. die inselförmigen Metallschicht kann eine in der Siliziumtechnologie übliche Aluminiumlegierung mit Kupfer- und / oder Siliziumanteilen oder ein sonstiges Metallsystem sein. Auf der Rückseite ist ein lötfähiges Metallsystem 11, beispielsweise aus einer Schichtenfolge Ti, NiV und Ag, aufgebracht.

Üblicherweise befindet sich der Drainkontakt 11 auf einem positiven Potential, während sich der Sourceanschluss auf Massepotential befindet. Wird an den Gateanschluss, bezogen auf den Sourcekontakt, eine ausreichend hohe, positive Gatespannung VG angelegt, bildet sich ein dünner Elektroneninversionskanal im Bodygebiet 6 an der Grenzfläche zum Gateoxid 4. Die Gatespannung VG muss dabei höher als die Threshholdspannung VTH des Transistors sein. Der Inversionskanal erstreckt sich dabei vom $n^+$-dotierten Sourcegebiet 8 bis zum n-dotierten Epigebiet 2. Damit ist ein durchgängiger Elektronenpfad vom Sourcebis zum Drainkontakt geschaffen. Der Transistor leitet.

Da der Stromfluss nur durch Majoritätsträger, bei denen es sich um Elektronen handelt, erfolgt, kann der Stromfluss schnell unterbrochen werden. Das Bauelement schaltet im Gegensatz zu herkömmlichen bipolaren Bauelementen sehr schnell.

Die Dotierungskonzentration und Dicke des n-dotierten Gebiets (Epischicht) 2 wird durch die Sperrspannung des Transistors bestimmt. Je höher die Sperrspannung eines MOSFETs gewählt wird, desto schwächer dotiert und desto dicker muss das Gebiet 2 sein. Da sich am Epigebiet ein ohmscher Spannungsabfall ausbildet erhöht sich dadurch der gesamte Einschaltwiderstand Rdson. Bei hohen Sperrspannungen dominiert dieser Anteil. Deshalb sind MOSFETs für Sperrspannungen über 200V im Allgemeinen nicht geeignet.

Aus der US 6,621,121 B2 ist bereits ein vertikaler MOSFET bekannt, der einen reduzierten Einschaltwiderstand aufweist. Dieser bekannte MOSFET enthält ein Halbleitersubstrat mit einer Vielzahl von Halbleiter-Mesas, die durch eine Vielzahl von streifenförmigen Gräben voneinander getrennt sind. Diese Gräben erstrecken sich parallel zueinander und verlaufen in einer ersten Richtung quer über das Substrat. Des Weiteren weist der bekannte MOSFET eine Vielzahl von innerhalb der Vielzahl der streifenförmigen Gräben angeordneten versteckten, isolierten Sourceefektroden auf. Ferner enthält der bekannte MOSFET eine Vielzahl von isolierten Gateelektroden, die parallel zueinander über die Vielzahl der Halbleiter-Mesas bis in flache Gräben verlaufen, die in der genannten Vielzahl von versteckten isolierten Sourcelektroden vorgesehen sind. Außerdem weist der bekannte MOSFET eine Oberflächen-Sourcelektrode auf dem genannten Halbleitersubstrat auf, die elektrisch mit der Vielzahl der versteckten, isolierten Sourcelektroden kontaktiert ist und mit dem zumindest einen Basisbereich in jeder der Vielzahl der Halbleitermesas einen Ohmschen Kontakt hat.

Aus der DE 10 2009 000 135 A1 ist bereits ein Halbleiterbauelement bekannt, das eine Driftzone eines ersten Leistungstyps und wenigstens eine in der Driftzone angeordnete Schottkymetallzone aufweist.

Offenbarung der Erfindung

Eine Halbleiteranordnung mit den im Anspruch 1 angegebenen Merkmalen weist demgegenüber den Vorteil auf, dass sie einfach realisierbar ist, neben der Reduzierung des Einschaltwiderstandes auch eine Erweiterung des Sperrspannungsbereiches ermöglicht und in besonderem Maße auch für Majoritätsträgerbauelemente geeignet ist. Eine Halbleiteranordnung gemäß der Erfindung weist mehrere gefloatete Schottkykontakte auf, die im Bereich des Epigebietes der Halbleiteranordnung vorgesehen sind. Unter einem gefloateten Schottkykontakt versteht man dabei einen Schottkykontakt, bei dem das Schottkymetall keine galvanische Verbindung zu anderen Kontakten aufweist.

Aufgrund dieser mehreren gefloateten Schottkykontakte bildet sich in den Epischichten jeweils eine periodisch homogene Feldverteilung sowie eine nahezu lineare Spannungsverteilung aus. Die Dotierkonzentration der Epischichten für eine vorgegebene Durchbruchsspannung kann höher gewählt werden als bei bekannten MOSFETS. Der Einschaltwiderstand ist reduziert.

Nachfolgend werden Ausführungsbeispiele für eine Halbleiteranordnung gemäß der Erfindung anhand der Figuren 2 - 8 näher erläutert. Es zeigt

- Figur 2 eine Schnittdarstellung einer Zelle eines MOSFETs gemäß einem ersten Ausführungsbeispiel für die Erfindung,
- Figur 3 eine Schnittdarstellung eines MOSFETs gemäß dem ersten Ausführungsbeispiel, in welcher drei Zellen des MOSFETs dargestellt sind,
- Figur 4 ein Diagramm zur Veranschaulichung der Verteilung des elektrischen Feldes im Durchbruch eines MOSFETs gemäß dem ersten Ausführungsbeispiel im Bereich eines Mesa-Streifens,
- Figur 5 ein Diagramm zur Veranschaulichung der Spannungsverteilung im Durchbruch eines MOSFETs gemäß dem ersten Ausführungsbeispiel im Bereich eines Mesa-Streifens,
- Figur 6 eine Schnittdarstellung eines MOSFETs gemäß einem Beispiel.
- Figur 7 eine Schnittdarstellung einer Zelle einer pn-Diode als ein zweites Ausführungsbeispiel für die Erfindung und
- Figur 8 eine Schnittdarstellung einer Zelle einer pn-Diode.

Die Figur 2 zeigt eine Schnittdarstellung einer Zelle eines MOSFETs gemäß einem ersten Ausführungsbeispiel für die Erfindung. Der MOSFET weist eine Vielzahl derartiger Zellen auf, die parallel zueinander angeordnet sind, wobei sich jede dieser Zellen in einer Richtung senkrecht zur Zeichenebene erstreckt.

Der dargestellte MOSFET enthält ein hoch $n^+$-dotiertes Siliziumsubstrat 1, eine sich darüber befindende n-dotierte Siliziumschicht 2 (Epischicht), in die eine Vielzahl von Gräben (Trenches) 3 eingebracht ist. Die Gräben 3 haben vorzugsweise eine rechteckige Form oder eine U-Form oder eine dazu ähnliche Form. Die Gräben 3 können in einer Streifenanordnung oder in Form von Inseln angeordnet sein, wobei die Inseln beispielsweise kreisförmig oder sechseckig gestaltet sind. Die Gräben 3 werden vorzugsweise durch ein Ätzen in die Epischicht 2 hergestellt. An den Seitenwänden der Gräben befindet sich im oberen Teil eine dünne, meist aus Siliziumdioxid bestehende, dielektrische Schicht 4. Innerhalb der Gräben schließt sich an die Seitenwände ein Bereich aus einem leitfähigen Material 5, beispielsweise dotiertem Polysilizium an. Die Oxidschicht 4 dehnt sich bis unterhalb des Bereichs 5 aus, ist dort aber etwas dicker ausgeführt (Bereich 4a). Zwischen den Gräben befindet sich eine p-dotierte Schicht (p-well) 6. In diese p-dotierte Schicht sind an der Oberfläche hoch $n^+$-dotierte Bereiche 8 (Source) und hoch $p^+$-dotierte Bereiche 7 (zum elektrischen Anschluss der p-well) eingebracht. Die Oberfläche der gesamten Struktur ist mit einer leitfähigen Schicht 9, beispielsweise mit Aluminium, bedeckt, die mit den $p^+$- bzw. $n^+$-dotierten Schichten 7 und 8 einen ohmschen Kontakt herstellt. Eine dicke dielektrische Schicht 10, beispielsweise eine CVD-Oxidschicht, isoliert die leitfähige Polysiliziumschicht 5 von der Metallisierung 9. Die Polysilizumschichten 5 sind miteinander und mit einem nicht eingezeichneten metallischen Gatekontakt galvanisch verbunden. Auf der Rückseite des Chips befindet sich ebenfalls eine Metallisierungsschicht 11, die den elektrischen Kontakt zum hoch $n^+$-dotierten Siliziumsubstrat 1 bildet. Die Metallschicht 9 bildet den Sourcekontakt S, die Metallschicht 11 den Drainkontakt D und die nicht eingezeichnete inselförmige Metallschicht den Gatekontakt G des MOSFETs.

Im Unterschied zur Anordnung nach Fig.1 enden die Trenchbereiche 3 nicht mit der Oxidschicht 4 bzw. 4a, sondern unterhalb von 4a sind noch weitere alternierende Schichten, bei denen sich Schottkymetall 12 und weitere Oxidschichten 14 abwechseln, angeordnet. Dabei werden als Schottkymetalle alle Metalle und alle Silicide verstanden, die mit den anschließenden n-dotierten Gebieten 2 auf beiden Seiten einen (nicht ohmschen) Schottky-Kontakt 70 bilden. Beispielsweise kann das Material 12 Nickel oder NiSi sein. Im gezeigten Beispiel befinden sich 5 floatende Schottkyschichten 12 unterhalb des Oxidbereichs 4a, die jeweils wiederum durch eine dielektrische Schicht 14 voneinander isoliert sind. Der letzte gefloatete Schottky-Kontakt überdeckt den Trenchboden. Natürlich können auch mehr oder weniger floatende Schottkyschichten 12 vorgesehen sein.

Die Figur 3 zeigt eine Schnittdarstellung eines MOSFETs gemäß dem ersten Ausführungsbeispiel, in welcher drei benachbarte Zellen des MOSFETs dargestellt sind. Aus der Figur 3 ist ersichtlich, dass die in die n-Epischicht 2 eingeätzten Gräben (Trenches) 3 eine Breite Wt und einen Abstand D_epi zum $n^+$-Substrat 1 aufweisen. Der Abstand der Mesa-Bereiche zwischen den benachbarten Gräben 3 beträgt Wm. Die Schottky-Kontakte 12 haben jeweils eine Dicke D_sk und sind in einem Abstand D_gap voneinander platziert. D_gap entspricht der Dicke der Oxidschichten 14 (siehe Figur 2). Die Dicke des Gateoxids 4 beträgt t_ox und die des unteren dickeren Oxids beträgt t_oxa. Die Anzahl der floatenden Schottkygebiete 12 sei Z. Im gezeigten Beispiel ist Z = 5 gewählt.

Bei ausreichend hoher positiver Gatespannung VG (größer als die Schwellspannung VTH) wird der MOSFET eingeschaltet. Es fließt ein Elektronenstrom vom Sourcegebiet 8 über den Inversionskanal im p-Gebiet 6 zum Epi- bzw. Substratbereich 2 bzw. 1.

In der Sperrrichtung bildet sich in der unter dem Bodygebiet 6 befindlichen n-Epischicht 2 eine Raumladungszone aus. Die Raumladungszone dehnt sich mit steigender Spannung in der Richtung zum Substrat 1 aus. Falls die Raumladungszone bei einer Spannung V1 den ersten gefloateten Schottky-Kontakt erreicht, wird diese Spannung V1 von dem ersten gefloateten Schottky-Kontakt übernommen. Die Raumladungszone dehnt sich mit weiter steigender Spannung in Richtung Trenchboden bzw. Substrat weiter aus. Die Spannung an dem ersten gefloateten Schottky-Kontakt bleibt unverändert.

Analog erreicht die Raumladungszone bei einer höheren Spannung Vn den n-ten gefloateten Schottky-Kontakt. Dabei übernimmt der n-te gefloatete Schottky-Kontakt die Spannung Vn. Wiederum bleibt bei weiter steigender Spannung die Spannung am n-ten gefloateten Schottky-Kontakt unverändert.

Falls die Weite D_sk und der Abstand D_gap in der Struktur des MOSFETs für alle Schottky-Kontakte 12 gleich gewählt sind, liegt im Mesa-Bereich (Abstand Wm) des Gebiets 2 eine periodisch homogene Feldverteilung vor. Diese Feldverteilung ist in der Figur 4 veranschaulicht, in welche längs der Abszisse der Weg X im Mesabereich entlang der Gräben in Richtung zum Substrat 1 und längs der Ordinate die elektrische Feldstärke E aufgetragen sind. Die Rechtecke unterhalb der Abszisse X symbolisieren dabei die Lage der floatenden Schottkykontakte. Es ist ersichtlich, dass sich die Feldverteilung im Mesabereich nach einem Abstand (D_sk + D_gap) solange wiederholt, bis der Trenchboden erreicht ist.

Die Figur 5 zeigt ein Diagramm der zugehörigen Spannungsverteilung im Mesa-Bereich, wobei auch in der Figur 5 die Rechtecke unterhalb der Abszisse X die Lage der floatenden Schottkykontakte symbolisieren. Es ist ersichtlich, dass die Spannungsverteilung in den Mesabereichen jeweils linear ist. Lediglich im Bereich der Schottkykontakte befinden sich kurze Bereiche konstanter Spannung.

Im Unterschied zu konventionellen Anordnungen nimmt die Sperrspannung mit zunehmender Anzahl Z der floatenden Schottkykontakte 12 zu. Dadurch erzielt man eine höhere Sperrspannung bzw. man kann bei vergleichbarer Sperrspannung eine höhere Dotierung des Epigebietes 2 wählen. Damit reduziert sich der ohmsche Spannungsabfall im eingeschalteten Zustand der Halbleiteranordnung. Der Einschaltwiderstand Rdson wird kleiner. Somit wird es möglich, Trench-MOSFETs für höhere Sperrspannungen bei niedrigem Einschaltwiderstand auszulegen.

Die Figur 6 zeigt eine Schnittdarstellung einer Zelle eines MOSFETs gemäß einem Beispiel. Der Aufbau dieses MOSFETs stimmt mit dem Aufbau des anhand der Figur 2 erläuterten MOSFETs überein. Der in der Figur 6 veranschaulichte MOSFET unterscheidet sich von dem in der Figur 2 gezeigten MOSFET lediglich dadurch, dass die beim MOSFET gemäß der Figur 2 vorgesehenen Oxidschichten 14 durch n-dotierte Polysiliziumschichten oder durch Siliziumschichten 13 ersetzt sind. Vorzugsweise entspricht die Dotierung der Schichten 13 der Dotierung der n-Epischicht 2. Anstelle der Oxidschichten 14 können beispielsweise auch andere dielektrische Materialien wie $Si_3N_4$, SON oder $HfO_2$ verwendet werden.

Alternativ zu dem vorstehend beschriebenen Ausführungsbeispiel, das jeweils mit Gräben versehene MOSFETs betrifft, kann das erfindungsgemäße Prinzip einer Verwendung von gestapelten, floatenden Schottkykontakten auch bei anderen Halbleiteranordnungen verwendet werden, beispielsweise bei DMOS-Transistoren oder bei IGBTs. Nachfolgend wird das erfindungsgemäße Prinzip am Beispiel einer hochsperrenden pn-Diode aufgezeigt.

Die Figur 7 zeigt eine Schnittdarstellung einer Zelle einer pn-Diode als ein zweites Ausführungsbeispiel für die Erfindung. Diese pn-Diode enthält ein hoch $n^+$-dotiertes Siliziumsubstrat 1 und eine sich darüber befindende n-dotierte Siliziumschicht 2 (Epischicht), in die eine Vielzahl von Gräben bzw. Trenches 3 eingebracht ist. Zwischen den Gräben befindet sich eine p-dotierte Schicht 6 (p-well). In diese p-dotierte Schicht 6 ist an ihrer Oberfläche ein hoch $p^+$-dotierter Bereich 7 zum elektrischen Anschluss der p-dotierten Schicht 6 eingebracht. Die Oberfläche der gesamten Struktur ist mit einer leitfähigen Schicht 9, beispielsweise mit Aluminium, bedeckt. Diese leitfähige Schicht 9 bildet mit dem hoch $p^+$-dotierten Bereich 7 einen ohmschen Kontakt. Auf der Rückseite des Chips befindet sich ebenfalls wieder eine Metallisierungsschicht 11, die den elektrischen Kontakt zum hoch $n^+$-dotierten Siliziumsubstrat 1 bildet.

Auch bei diesem Ausführungsbeispiel sind die Gräben 3 mit einer Abfolge dielektrischen Schichten 14a bzw. 14 und floatenden Schottkykontakten 12 bzw. 70 gefüllt. Die p-dotierte Schicht 6 und das schwach $n^-$-dotierte Gebiet 2 bilden den pn-Übergang der Diode. Das p-dotierte Gebiet 6 ist an seiner Oberfläche mit einer hoch $p^+$-dotierten Schicht 7 versehen. Analog zu der oben beschriebenen Wirkungsweise kann mit einer derartigen Struktur die Sperrspannung höher gewählt werden als bei einer üblichen pn-Diode, die diese Struktur nicht aufweist. Alternativ dazu kann die Dotierung des $n^-$-dotierten Gebietes 2 erhöht und damit der Bahnwiderstand reduziert werden.

Analog zum Ausführungsbeispiel gemäß Figur 6 können die dielektrischen Schichten 14 durch geeignete n-dotierte Polysiliziumschichten oder Siliziumschichten 13 ersetzt werden.

Die Figur 8 zeigt eine Schnittdarstellung einer Zelle einer pn-Diode.

Auch diese pn-Diode enthält ein hoch $n^+$-dotiertes Siliziumsubstrat 1 und eine sich darüber befindende n-dotierte Siliziumschicht 2 (Epischicht). Oberhalb der n-dotierten Siliziumschicht 2 befindet sich eine p-dotierte Schicht 6. In diese p-dotierte Schicht 6 ist an ihrer Oberfläche eine hoch $p^+$-dotierte Schicht 7 zum elektrischen Anschluss der p-dotierten Schicht eingebracht. Die Oberfläche der gesamten Struktur ist mit einer leitfähigen Schicht 9, beispielsweise mit Aluminium, bedeckt. Diese leitfähige Schicht 9 bildet mit der hoch $p^+$-dotierten Schicht 7 einen ohmschen Kontakt. Auf der Rückseite des Chips befindet sich ebenfalls wieder eine Metallisierungsschicht 11, die den elektrischen Kontakt zum hoch $n^+$-dotierten Siliziumsubstrat bildet.

Im Unterschied zur Anordnung gemäß der Figur 7 weist die in der Figur 8 gezeigte Anordnung keine Gräben auf. Die floatenden Schottkykontakte 70, 12 befinden sich innerhalb des n-dotierten Gebietes 2, so dass sich zwischen zwei benachbarten Schottkykontakten jeweils ein Bereich des n-dotierten Gebietes 2 befindet. Die flächig ausgebildete, p-dotierte Schicht 6 und das schwach $n^-$-dotierte Gebiet 2 bilden den pn-Übergang der Diode. Die flächig ausgebildete p-dotierte Schicht 6 ist an ihrer Oberfläche mit der ebenfalls flächig ausgebildeten, hoch $p^+$-dotierten Schicht 7 versehen. Analog zu der oben beschriebenen Wirkungsweise kann mit einer derartigen Struktur die Sperrspannung höher gewählt werden als bei einer üblichen pn-Diode, die diese Struktur nicht aufweist. Alternativ dazu kann die Dotierung des n-dotierten Gebietes 2 erhöht und damit der Bahnwiderstand reduziert werden.

Bei allen oben beschriebenen Ausführungsbeispielen können die Halbleiteranordnungen eine lötbare Vorder- und Rückseitenmetallisierung aufweisen, so dass sie in einfacher Weise in einer geeigneten Schaltungsumgebung eingelötet bzw. kontaktiert werden können. Vorzugsweise sind die beschriebenen Halbleiteranordnungen gemäß Figur 7 und 8 (Dioden) dann jeweils in einem Einpressdiodengehäuse montiert. Eine bevorzugte Anwendung einer Halbleiteranordnung gemäß der Erfindung ist eine Anwendung in einem Gleichrichter eines Kraftfahrzeuggenerators.

Alternativ zu den oben beschriebenen Ausführungsbeispielen können alle Halbleiterschichten jeweils durch eine Halbleiterschicht gegensätzlichen Leitfähigkeitstyps ersetzt sein und die Bezeichnungen der Source- und Drainanschlüsse bzw. der Anoden- und Kathodenanschlüsse vertauscht sein.

## Patentansprüche

1. Halbleiteranordnung, die eine auf einem hochdotierten Substrat (1) ersten Leitfähigkeitstyps befindliche Epischicht (2) des ersten Leitfähigkeitstyps, eine in die Epischicht (2) eingebrachte Schicht (6) eines zweiten Leitfähigkeitstyps und eine an der Oberfläche der Schicht (6) des zweiten Leitfähigkeitstyps vorgesehene hochdotierte Schicht (7) des zweiten Leitfähigkeitstyps aufweist, **dadurch gekennzeichnet, dass** zwischen der Schicht (6) des zweiten Leitfähigkeitstyps und dem hochdotierten Substrat (1) des ersten Leitfähigkeitstyps mehrere in Gräben (3) vorgesehene und in Richtung zum hochdotierten Substrat parallel zueinander angeordnete , gefloatete Schottkykontakte (70,12) alternierend mit weiteren dielektrischen Schichten (14) angeordnet sind.

2. Halbleiteranordnung nach Anspruch 1, **dadurch gekennzeichnet, dass** an der Oberfläche der Schicht (6) des zweiten Leitfähigkeitstyps des Weiteren eine hochdotierte Schicht (8) des ersten Leitfähigkeitstyps und eine hochdotierte Schicht (7) des zweiten Leitfähigkeitstyps vorgesehen sind, in die Epischicht (2) mindestens zwei mit dotiertem Polysilizium (5) gefüllte und mit dielektrischen Schichten (4,4a) bedeckte oberste Teile der Gräben (3) eingebracht sind, die dielektrischen Schichten (4a) an den Grabenböden der obersten Teile der Gräben (3) dicker ausgeführt sind als die dielektrischen Schichten (4) an den Seitenwänden der obersten Teile der Gräben (3) und dass sich zwischen der Schicht (6) des zweiten Leitfähigkeitstyps (p) und dem hochdotierten Substrat (1) des ersten Leitfähigkeitstyps jeweils eine alternierende Abfolge einer Metall- bzw. Silizidschicht (70,12) mit einer weiteren dielektrischen Schicht (14) befindet, wobei die Metall- bzw. Silizidschichten (70,12) mit der Epischicht (2) jeweils nicht ohmsche Schottkykontakte bilden .

3. Halbleiteranordnung nach Anspruch 2, **dadurch gekennzeichnet, dass** sich die dickere dielektrische Schicht (4a) unterhalb der Schicht (6) des zweiten Leitfähigkeitstyps befindet.

4. Halbleiteranordnung nach Anspruch 2 oder 3, **dadurch gekennzeichnet, dass** die Schottkykontakte (70,12) an der Grabenwand jeweils gefloatet sind.

5. Halbleiteranordnung nach einem der Ansprüche 2 - 4, **dadurch gekennzeichnet, dass** der dem hochdotierten Substrat (1) des ersten Leitfähigkeitstyps nächstliegende Schottkykontakt jeweils den Grabenboden überdeckt und einen Abstand (D_epi) zum hochdotierten Substrat (1) des ersten Leitfähigkeitstyps hat.

6. Halbleiteranordnung nach einem der Ansprüche 2 - 5, **dadurch gekennzeichnet, dass** die gefloateten Schottkykontakte (70,12) jeweils eine Weite (D_sk) und die zwischen den Schottkykontakten vorgesehenen dielektrischen Schichten (14) jeweils eine Weite (D-gap) aufweisen.

7. Halbleiteranordnung nach einem der Ansprüche 2 - 6, **dadurch gekennzeichnet, dass** zwischen benachbarten Gräben (3) der Halbleiteranordnung jeweils ein Mesabereich vorliegt, in welchem sich die Feldverteilung in einem Abstand D periodisch wiederholt, für den gilt:

$$D = D_sk + D_gap,$$

wobei D_sk die Weite der gefloateten Schottkykontakte (70,12) und D_gap die Weite der weiteren dielektrischen Schichten (14) ist.

8. Halbleiteranordnung nach Anspruch 7, **dadurch gekennzeichnet, dass** die Spannungsverteilung in den Mesabereichen jeweils linear ist.

9. Halbleiteranordnung nach Anspruch 1, **dadurch gekennzeichnet, dass** in die Epischicht (2) mindestens zwei mit einer dielektrischen Schicht (14a) gefüllte oberste Teile der Gräben (3) eingebracht sind, der Abstand der dielektrischen Schichten vom hochdotierten Substrat (1) des ersten Leitfähigkeitstyps kleiner ist als der Abstand der Schicht (6) des zweiten Leitfähigkeitstyps vom hochdotierten Substrat (1) des ersten Leitfähigkeitstyps und dass sich zwischen dem dem hochdotierten Substrat (1) des ersten Leitfähigkeitstyps zugewandten Ende der dielektrischen Schicht (14a) und dem hochdotiertem Substrat (1) des ersten Leitfähigkeitstyps jeweils eine alternierende Abfolge einer Metall- bzw. Silizidschicht (70,12) mit einer weiteren dielektrischen Schicht (14) befindet, wobei die Metall- bzw. Silizidschichten (70,12) mit der Epischicht jeweils nicht ohmsche Schottkykontakte bilden .

10. Halbleiteranordnung nach einem der vorhergehenden Ansprüche, **dadurch gekennzeichnet, dass** die parallel zueinander angeordneten Schottkykontakte (70,12) sich unterhalb der Bodydiode eines DMOS-Transistors oder unterhalb der Bodydiode eines IGBTs befinden.

11. Halbleiteranordnung nach einem der vorhergehenden Ansprüche, **dadurch gekennzeichnet, dass** sie eine lötbare Vorderseitenmetallisierung (9) und eine lötbare Rückseitenmetallisierung (11) aufweist.

12. Verwendung einer Halbleiteranordnung nach einem der Ansprüche 1 - 11 in einem Gleichrichter eines Kraftfahrzeuggenerators.

**Claims**

1. Semiconductor arrangement that has an epilayer (2) of a first conductivity type, situated on a heavily doped substrate (1) of the first conductivity type, a layer (6) of a second conductivity type, incorporated into the epilayer (2), and a heavily doped layer (7) of the second conductivity type, provided on the surface of the layer (6) of the second conductivity type, **characterized in that** between the layer (6) of the second conductivity type and the heavily doped substrate (1) of the first conductivity type there are arranged multiple floated Schottky contacts (70, 12) provided in trenches (3) and arranged in parallel with one another in the direction of the heavily doped substrate, in alternation with further dielectric layers (14).

2. Semiconductor arrangement according to Claim 1, **characterized in that** a heavily doped layer (8) of the first conductivity type and a heavily doped layer (7) of the second conductivity type are furthermore provided on the surface of the layer (6) of the second conductivity type, at least two uppermost portions of the trenches (3), which portions are filled with doped polysilicon (5) and covered with dielectric layers (4, 4a), are incorporated in the epilayer (2), the dielectric layers (4a) on the trench floors of the uppermost portions of the trenches (3) are thicker than the dielectric layers (4) on the side walls of the uppermost portions of the trenches (3), and **in that** between the layer (6) of the second conductivity type (P) and the heavily doped substrate (1) of the first conductivity type there is a respective alternating sequence of a metal or silicide layer (70, 12) with a further dielectric layer (14), wherein the metal or silicide layers (70, 12) each form non-resistive Schottky contacts with the epilayer (2).

3. Semiconductor arrangement according to Claim 2, **characterized in that** the thicker dielectric layer (4a) is situated below the layer (6) of the second conductivity type.

4. Semiconductor arrangement according to Claim 2 or 3, **characterized in that** the Schottky contacts (70, 12) are each floated on the trench wall.

5. Semiconductor arrangement according to one of Claims 2 - 4, **characterized in that** the Schottky contact closest to the heavily doped substrate (1) of the first conductivity type covers the trench floor in each case and is at a distance (D_epi) from the heavily doped substrate (1) of the first conductivity type.

6. Semiconductor arrangement according to one of Claims 2-5, **characterized in that** the floated Schottky contacts (70, 12) each have a length (D_sk) and the dielectric layers (14) provided between the Schottky contacts each have a length (D-gap).

7. Semiconductor arrangement according to one of Claims 2 - 6, **characterized in that** between adjacent trenches (3) of the semiconductor arrangement there is a respective mesa region in which the field distribution is periodically repeated at a distance D, for which the following applies:

$$D = D_sk + D_gap,$$

where D_sk is the width of the floated Schottky contacts (70, 12) and D_gap is the width of the further dielectric layers (14).

**8.** Semiconductor arrangement according to Claim 7, **characterized in that** the voltage distribution in each of the mesa regions is linear.

**9.** Semiconductor arrangement according to Claim 1, **characterized in that** at least two uppermost portions of the trenches (3), which portions are filled with a dielectric layer (14a), are incorporated in the epilayer (2), the distance of the dielectric layers from the heavily doped substrate (1) of the first conductivity type is shorter than the distance of the layer (6) of the second conductivity type from the heavily doped substrate (1) of the first conductivity type, and **in that** between that end of the dielectric layer (14a) that faces the heavily doped substrate (1) of the first conductivity type and the heavily doped substrate (1) of the first conductivity type there is a respective alternating sequence of a metal or silicide layer (70, 12) with a further dielectric layer (14), wherein the metal or silicide layers (70, 12) each form non-resistive Schottky contacts with the epilayer.

**10.** Semiconductor arrangement according to one of the preceding claims, **characterized in that** the Schottky contacts (70, 12) arranged in parallel with one another are situated below the body diode of a DMOS transistor or below the body diode of an IGBT.

**11.** Semiconductor arrangement according to one of the preceding claims, **characterized in that** it has a solderable front metallization (9) and a solderable rear metallization (11).

**12.** Use of a semiconductor arrangement according to one of Claims 1 - 11 in a rectifier of a motor vehicle generator.

## Revendications

**1.** Arrangement semiconducteur, qui possède, sur un substrat (1) fortement dopé d'un premier type de conductivité, une couche épitaxiale (2) du premier type de conductivité, une couche (6) d'un deuxième type de conductivité incorporée dans la couche épitaxiale (2) et une couche fortement dopée (7) disposée sur la surface de la couche (6) du deuxième type de conductivité, **caractérisé en ce qu'**entre la couche (6) du deuxième type de conductivité et le substrat (1) fortement dopé du premier type de conductivité sont disposés, en alternance avec des couches diélectriques (14) supplémentaires, plusieurs contacts Schottky (70, 12) rendus flottants, disposés en parallèle les uns aux autres dans la direction du substrat fortement dopé et se trouvant dans des tranchées (3).

**2.** Arrangement semiconducteur selon la revendication 1, **caractérisé en ce qu'**une couche fortement dopée (8) du premier type de conductivité et une couche fortement dopée (7) du deuxième type de conductivité se trouvent en outre à la surface de la couche (6) du deuxième type de conductivité, au moins deux parties supérieures des tranchées (3) remplies de polysilicium dopé (5) et recouvertes de couches diélectriques (4, 4a) sont incorporées dans la couche épitaxiale (2), les couches diélectriques (4a) sont réalisées plus épaisses au niveau des fonds de tranchée des parties supérieures des tranchées (3) que les couches diélectriques (4) au niveau des parois latérales des parties supérieures des tranchées (3) et **en ce qu'**une séquence alternée d'une couche de métal ou de siliciure (70, 12) avec une couche diélectrique (14) supplémentaire se trouve respectivement entre la couche (6) du deuxième type de conductivité (p) et le substrat (1) fortement dopé du premier type de conductivité, les couches de métal ou de siliciure (70, 12) formant avec la couche épitaxiale (2) des contacts Schottky respectivement non ohmiques.

**3.** Arrangement semiconducteur selon la revendication 2, **caractérisé en ce que** la couche diélectrique (4a) plus épaisse se trouve au-dessous de la couche (6) du deuxième type de conductivité.

**4.** Arrangement semiconducteur selon la revendication 2 ou 3, **caractérisé en ce que** les contacts Schottky (70, 12) au niveau de la paroi de tranchée sont respectivement rendus flottants.

**5.** Arrangement semiconducteur selon l'une des revendications 2 à 4, **caractérisé en ce que** le contact Schottky le plus proche du substrat (1) fortement dopé du premier type de conductivité recouvre respectivement le fond de tranchée et présente un écart (D_epi) par rapport au substrat (1) fortement dopé du premier type de conductivité.

**6.** Arrangement semiconducteur selon l'une des revendications 2 à 5, **caractérisé en ce que** les contacts Schottky (70, 12) rendus flottants présentent respectivement une largeur (D_sk) et les couches diélectriques (14) qui se trouvent entre les contacts Schottky présentent respectivement une largeur (D-gap).

**7.** Arrangement semiconducteur selon l'une des revendications 2 à 6, **caractérisé en ce qu'**une zone de mésa est respectivement présente entre les tranchées (3) voisines de l'arrangement semiconducteur, dans laquelle la distribution du champ se répète périodiquement à un écart D défini tel que :

$$D = D_sk + D_gap,$$

D_sk désignant la largeur des contacts Schottky (70, 12) rendus flottants et D_gap la largeur des couches diélectriques (14) supplémentaires.

**8.** Arrangement semiconducteur selon la revendication 7, **caractérisé en ce que** la distribution de tension dans les zones de mésa est respectivement linéaire.

**9.** Arrangement semiconducteur selon la revendication 1, **caractérisé en ce qu'**au moins deux parties supérieures des tranchées (3) remplies d'une couche diélectrique (14a) sont incorporées dans la couche épitaxiale (2), l'écart entre les couches diélectriques et le substrat (1) fortement dopé du premier type de conductivité est inférieur à l'écart entre la couche (6) du deuxième type de conductivité et le substrat (1) fortement dopé du premier type de conductivité et **en ce qu'**une séquence alternée d'une couche de métal ou de siliciure (70, 12) avec une couche diélectrique (14) supplémentaire se trouve respectivement entre l'extrémité de la couche diélectrique (14a) qui fait face au substrat (1) fortement dopé du premier type de conductivité et le substrat (1) fortement dopé du premier type de conductivité, les couches de métal ou de siliciure (70, 12) formant avec la couche épitaxiale des contacts Schottky respectivement non ohmiques.

**10.** Arrangement semiconducteur selon l'une des revendications précédentes, **caractérisé en ce que** les contacts Schottky (70, 12) disposés en parallèle les uns aux autres se trouvent au-dessous de la bodydiode d'un transistor DMOS ou au-dessous de la bodydiode d'un IGBT.

**11.** Arrangement semiconducteur selon l'une des revendications précédentes, **caractérisé en ce qu'**il possède une métallisation de face avant (9) apte au brasage et une métallisation de face arrière (11) apte au brasage.

**12.** Utilisation d'un arrangement semiconducteur selon l'une des revendications 1 à 11 dans un redresseur d'un alternateur de véhicule automobile.

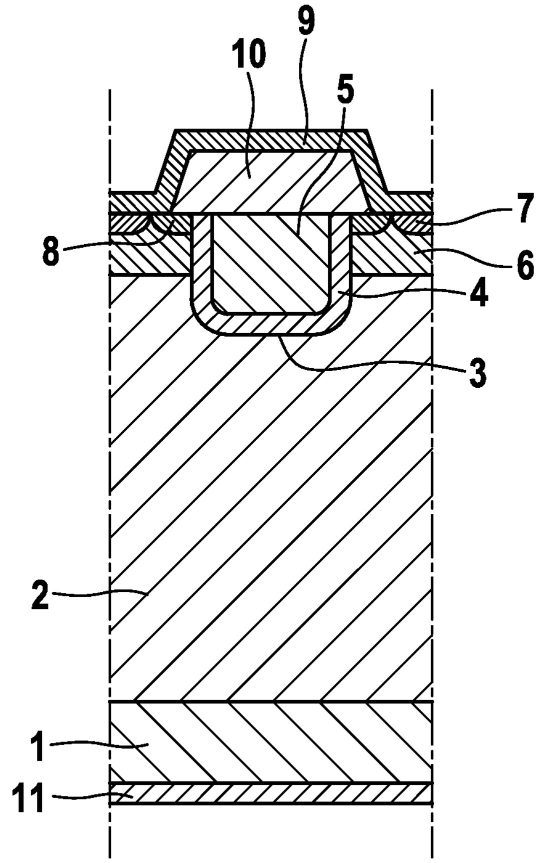


FIG. 1

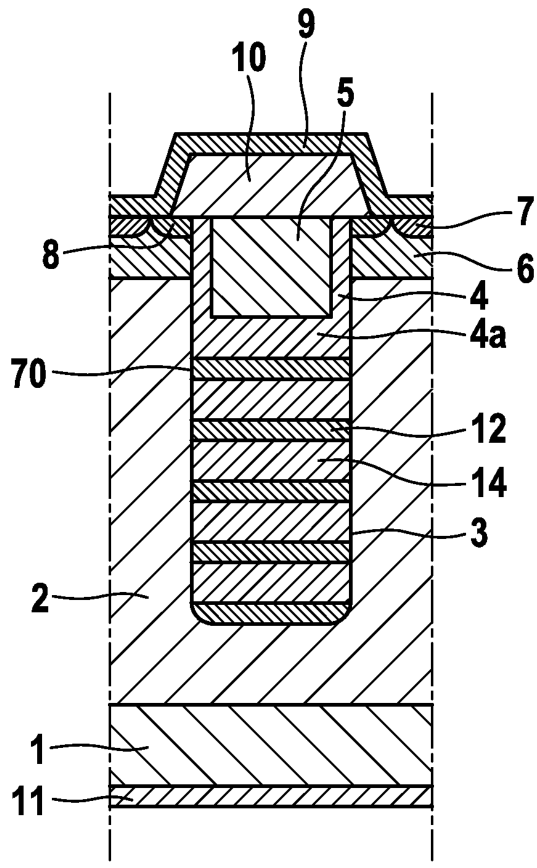


FIG. 2

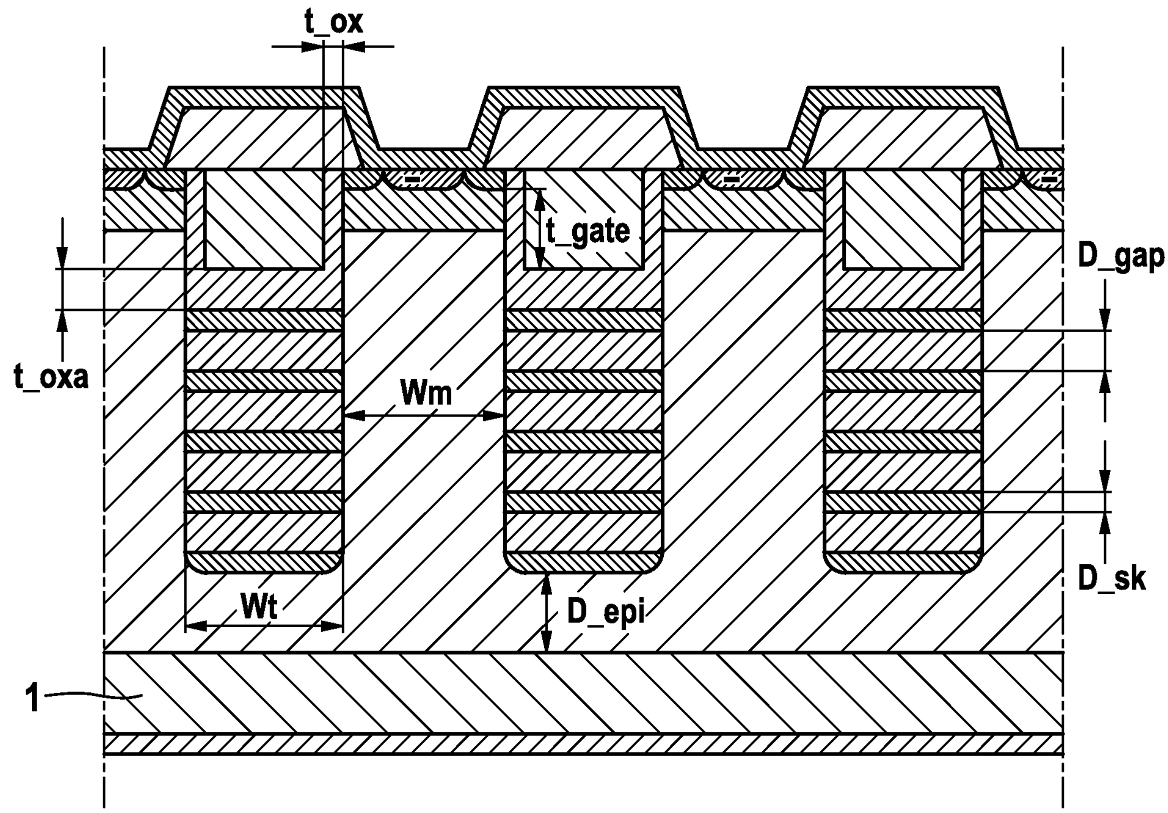


FIG. 3

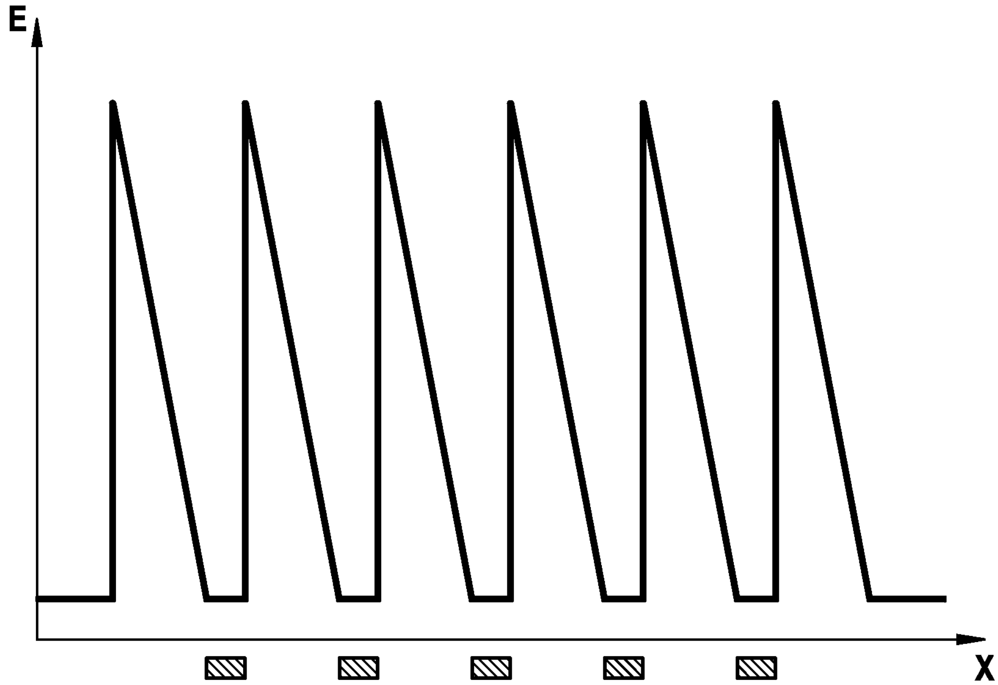


FIG. 4

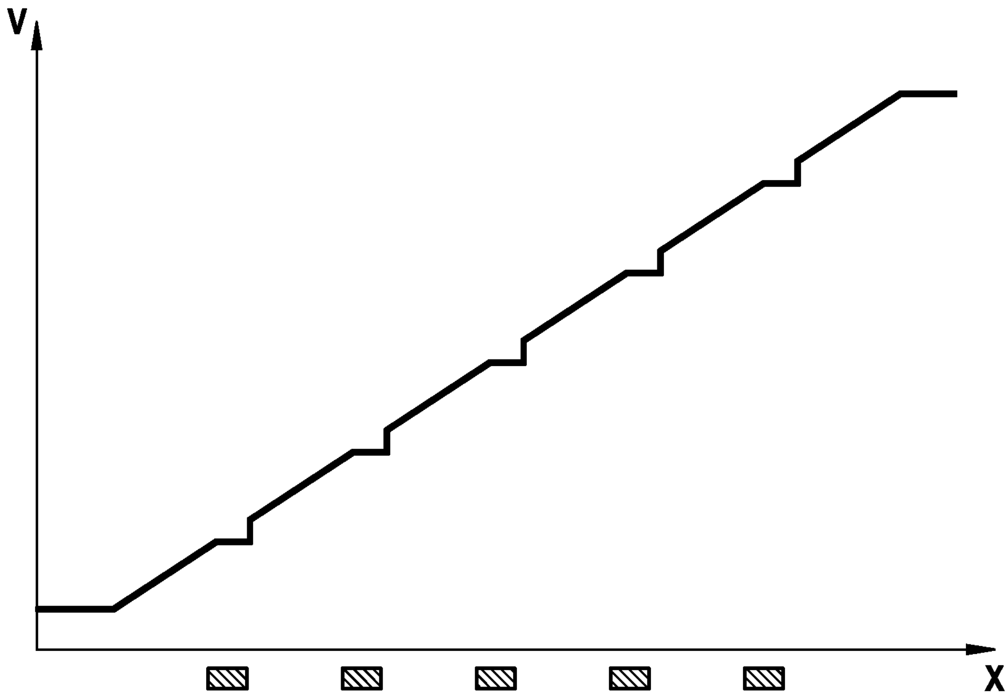


FIG. 5

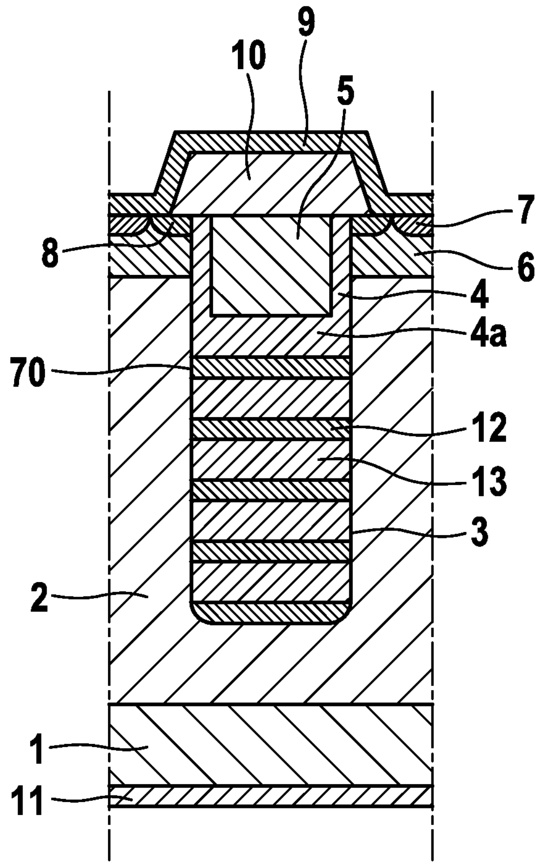


FIG. 6

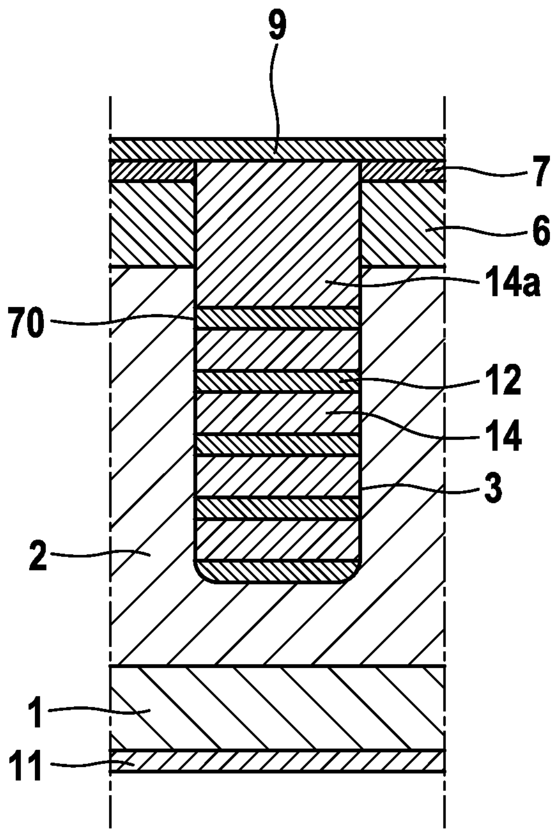


FIG. 7

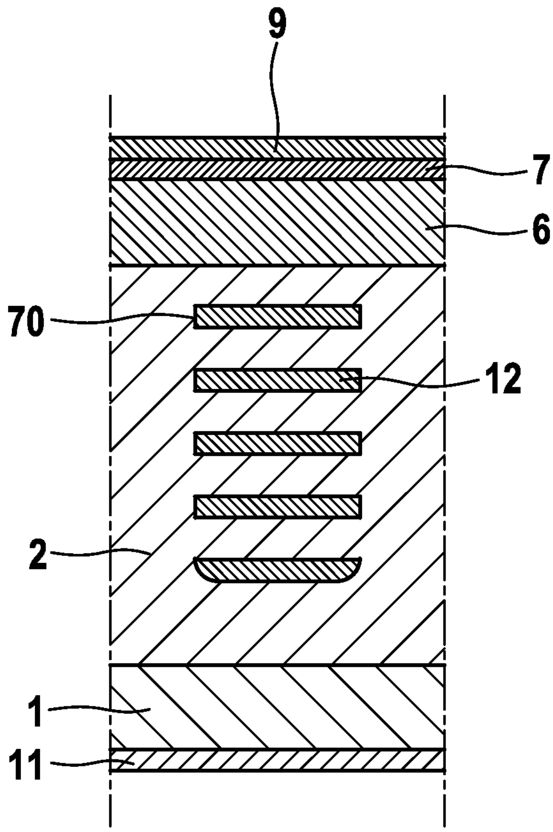


FIG. 8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 6621121 B2
- DE 102009000135 A1